# EUROPÄISCHE PATENTANMELDUNG

(11) **EP 3 503 698 A1**
(43) Veröffentlichungstag der Anmeldung: **26.06.2019**
(21) Anmeldenummer: 18212839.7
(22) Anmeldetag: 17.12.2018
(51) Int. Cl.: H05K 5/00, G07C 5/00

(54) **DIAGNOSEMODUL MIT EINEM DIAGNOSESTECKER**

(30) Priorität: 22.12.2017 DE 102017223701
(71) Anmelder: Continental Automotive GmbH, 30165 Hannover (DE)
(72) Erfinder: Gruler, Martin, 78554 Aldingen-Aixheim (DE); Fricker, Jochen, 78176 Blumberg (DE); Lange, Roland, 78086 Brigachtal (DE)

(57) **Zusammenfassung**

Die Erfindung bezieht sich auf ein Diagnosemodul 1 für ein Kraftfahrzeug mit einem Steckkontakte 10 aufweisenden Diagnosestecker 4 und mit einer Leiterplatte 6, wobei die Steckkontakte 10 mit der Leiterplatte 6 elektrisch kontaktiert sind und jeweils ein freies Steckkontaktende 12 aufweisen und wobei die Leiterplatte 6 senkrecht zu den freien Steckkontaktenden 12 angeordnet ist. Für einen einfachen und zuverlässigen Aufbau des Diagnosemoduls schlägt die Erfindung vor, dass die Steckkontakte 10 jeweils ein dem jeweiligen freien Steckkontaktende 12 abgewandtes festes Steckkontaktende 14 aufweisen, wobei die festen Steckkontaktenden 14 in die festen Steckkontaktenden 14 in der Ebene der Leiterplatte 6 jeweils vollständig umschließende Ausnehmungen 8 der Leiterplatte 6 eingreifen und jeweils mit der Leiterplatte 6 elektrisch kontaktiert sind.

## Beschreibung

Die Erfindung bezieht sich auf ein Diagnosemodul für ein Kraftfahrzeug mit einem Steckkontakte aufweisenden Diagnosestecker und mit einer Leiterplatte, wobei die Steckkontakte mit der Leiterplatte elektrisch kontaktiert sind und jeweils ein freies Steckkontaktende aufweisen und wobei die Leiterplatte senkrecht zu den freien Steckkontaktenden angeordnet ist.

Ein vorgenanntes Diagnosemodul ist als Diagnosemodul für ein Fahrzeugdiagnosesystem bekannt. Das Diagnosemodul weist einen Diagnosestecker auf, mittels welchem das Diagnosemodul mit einer korrespondierenden Diagnosesteckdose eines Kraftfahrzeugs verbunden werden kann. Der Diagnosestecker ist mit einer Leiterplatte des Diagnosemoduls verbunden, wobei die Leiterplatte des bekannten Diagnosemoduls eine fertigungsaufwendige Ausgestaltung zur elektrischen Verbindung von Leiterplatte und Steckkontakten des Diagnosesteckers mittels einer Kantenkontaktierung erfordert.

Aufgabe der Erfindung ist es, ein Diagnosemodul der eingangs genannten Art zu schaffen, das einen einfachen und zuverlässigen Aufbau aufweist.

Diese Aufgabe wird erfindungsgemäß mit einem Diagnosemodul der eingangs genannten Art und dadurch gelöst, dass die Steckkontakte jeweils ein dem jeweiligen freien Steckkontaktende abgewandtes festes Steckkontaktende aufweisen, wobei die festen Steckkontaktenden in die festen Steckkontaktenden in der Ebene der Leiterplatte jeweils vollständig umschließende Ausnehmungen der Leiterplatte eingreifen und jeweils mit der Leiterplatte elektrisch kontaktiert sind.

Von besonderem Vorteil ist bei der Erfindung, dass die festen Steckkontaktenden, das heißt die Enden der Steckkontakte, welche Enden nicht mit einer Diagnosesteckdose zum Beispiel eines Kraftfahrzeugs, sondern mit der Leiterplatte des Diagnosemoduls elektrisch kontaktiert werden, in Ausnehmungen der Leiterplatte eingreifen und dass diese Ausnehmungen die Steckkontaktenden in der Leiterplattenebene jeweils vollständig umschließen. Somit bilden die Ausnehmungen jeweils beispielsweise einen geschlossenen Rahmen um das jeweilige feste Steckkontaktende. Die festen Steckkontaktenden sind jeweils an und/oder in der jeweiligen, mit dem Steckkontaktende korrespondierenden Ausnehmung mit der Leiterplatte elektrisch kontaktiert. Die Erfindung stellt ein Diagnosemodul zur Verfügung, das auf engstem Bauraum einen einfachen und eine hohe und dauerhafte Betriebssicherheit gewährleistenden Aufbau aufweist und dabei gleichzeitig kostengünstig herstellbar ist.

Der Diagnosestecker des Diagnosemoduls ist zur Verbindung mit einer Diagnosesteckdose, insbesondere in einem Kraftfahrzeug, vorgesehen. Dabei sind die freien Steckkontaktenden der Steckkontakte des Diagnosesteckers zum Einführen in eine jeweils korrespondierende Steckbuchse der Diagnosesteckdose vorgesehen. Die senkrechte Anordnung der Leiterplatte in Bezug auf die freien Steckkontaktenden bedeutet somit, dass die Leiterplatte senkrecht zu einer Steckrichtung, das heißt senkrecht zu einer einen Verbindungsvorgang von Diagnosestecker und Diagnosesteckdose angebenden Richtung, angeordnet ist.

Zusätzliche vorteilhafte Weiterbildungen der Erfindung sind in den Unteransprüchen angegeben.

Man könnte sich beispielsweise vorstellen, dass die Ausnehmungen topfförmig in der Leiterplatte ausgebildet sind. Hingegen sind die Ausnehmungen gemäß einer vorteilhaften Weiterbildung der Erfindung Durchgangsausnehmungen der Leiterplatte. Damit wird die Herstellung des Diagnosemoduls vorteilhaft vereinfacht.

Einer vorteilhaften Weiterbildung der Erfindung entsprechend durchgreifen die festen Steckkontaktenden die Leiterplatte durch die jeweilige Ausnehmung. Vorzugsweise können die festen Steckkontaktenden die Leiterplattenoberfläche um ein gewisses, geringes Maß überragen. Somit kann eine besonders zuverlässige Montage und elektrische Kontaktierung erreicht werden.

Gemäß einer vorteilhaften Weiterbildung der Erfindung sind die Ausnehmungen in einem Randbereich der Leiterplatte angeordnet. Dadurch kann sowohl die Herstellung des Diagnosemoduls vereinfacht als auch das elektronische Layout der Leiterplatte verbessert werden. Beispielsweise sind die Ausnehmungen in einem Randbereich mit einem Abstand von 0,3 mm bis 0,7 mm von einem Rand der Leiterplatte angeordnet.

Von besonderem Vorteil für eine einfache und sichere elektrische Kontaktierung der festen Steckkontaktenden mit der Leiterplatte ist es, wenn gemäß einer Weiterbildung der Erfindung die festen Steckkontaktenden in der jeweiligen Ausnehmung mit der Leiterplatte elektrisch kontaktiert, zum Beispiel verlötet, sind.

Ein übliches Diagnosemodul kann beispielsweise 16 Steckkontakte zur Verbindung mit einer Diagnosesteckdose aufweisen. Besonders kostengünstig und herstellungsvereinfachend ist es hingegen, wenn entsprechend einer vorteilhaften Weiterbildung der Erfindung der Diagnosestecker höchstens zehn, vorzugsweise höchstens sieben, weiter vorzugsweise genau sieben, Steckkontakte aufweist.

Gemäß einer anderen vorteilhaften Weiterbildung der Erfindung weisen die Steckkontakte jeweils zwischen ihren freien Steckkontaktenden und ihren festen Steckkontaktenden eine S-förmige Abkröpfung auf. Dadurch können mechanische Belastungen der Steckkontakte, welche Belastungen bei einem Verbinden von Diagnosestecker und Diagnosesteckdose auftreten können, von der Leiterplatte, insbesondere von der elektrischen Verbindung von Leiterplatte und festen Steckkontaktenden, weitestgehend entkoppelt werden.

Einer vorteilhaften Weiterbildung der Erfindung entsprechend weisen die S-förmigen Abkröpfungen jeweils einen parallel zu der Leiterplatte verlaufenden Steckkontaktabschnitt auf. Auf diese Weise kann die Herstellung des Diagnosemoduls weiter vereinfacht werden.

Eine besonders zuverlässige und zugleich vergleichsweise kostengünstig herstellbare Anordnung der Steckkontakte in dem Diagnosestecker kann erreicht werden, wenn gemäß einer vorteilhaften Weiterbildung der Erfindung der Diagnosestecker ein Kunststoffbauteil, beispielsweise ein Kunststoffspritzgussbauteil, ist und die Steckkontakte in das Kunststoffbauteil, beispielsweise Kunststoffspritzgussbauteil, eingeformt, beispielsweise eingespritzt, sind. Die Steckkontakte sind dann teilweise von Kunststoffmaterial umgeben, zum Beispiel umspritzt. Dabei bleiben die freien Steckkontaktenden (zur Verbindung mit einer Diagnosesteckdose) und die festen Steckkontaktenden (zur elektrischen Kontaktierung mit der Leiterplatte) frei von Kunststoffmaterial. Die Steckkontakte sind vorzugsweise in einem mittleren Bereich zwischen freiem und festem Steckkontaktende mit Kunststoffmaterial umgeben.

Gemäß einer vorteilhaften Weiterbildung der Erfindung ist jeweils ein parallel zu der Leiterplatte verlaufenden Steckkontaktabschnitt in das Kunststoffbauteil, beispielsweise Kunststoffspritzgussbauteil, eingeformt, beispielsweise eingespritzt. Somit kann eine besonders stabile Anordnung der Steckkontakte in dem Diagnosestecker erreicht werden.

Ein Ausführungsbeispiel der Erfindung ist in der Zeichnung schematisiert und skizzenhaft dargestellt und wird im Folgenden näher beschrieben. Es zeigen
- Figur 1: ein Diagnosemodul in perspektivischer Ansicht von vorne,
- Figur 2: das Diagnosemodul nach Figur 1 in einer Explosionsansicht von vorne und schräg oben,
- Figur 3: das Diagnosemodul nach Figur 1 in einer Explosionsansicht von hinten und schräg oben,
- Figur 4: einen Ausschnitt aus dem Diagnosemodul nach Figur 1 in einer Schnittansicht,
- Figur 5A: das Diagnosemodul nach Figur 1 in einer Ansicht von vorne,
- Figur 5B: eine Schnittansicht des Diagnosemoduls nach Figur 1 entlang Linie A - A in Figur 5A,
- Figur 6: das Diagnosemodul nach Figur 1 in einer Ansicht von hinten und
- Figur 7: das Diagnosemodul nach Figur 1 in einer perspektivischen Ansicht von hinten.

Sich jeweils entsprechende Elemente sind in allen Figuren mit gleichen Bezugszeichen versehen.

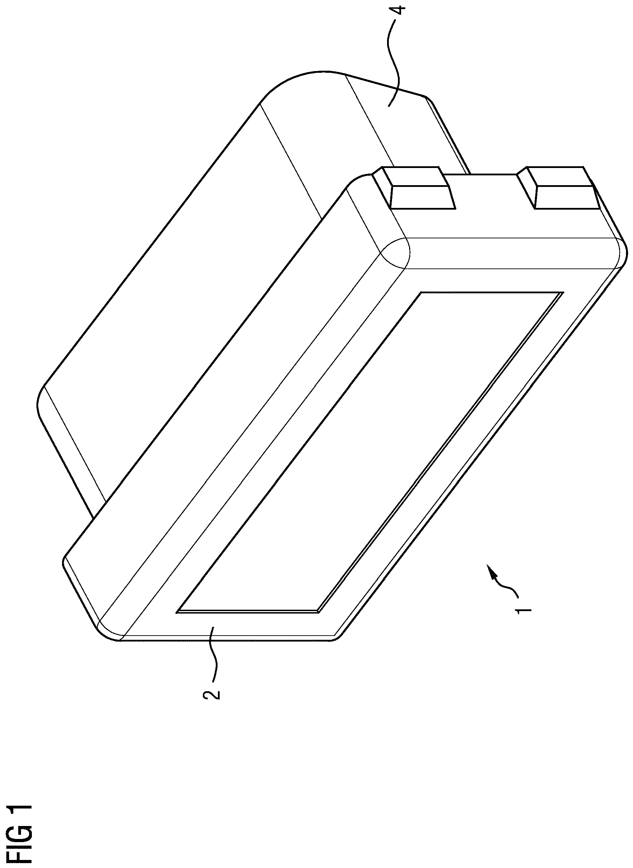

Figur 1 zeigt in einer perspektivischen Ansicht von vorne ein Diagnosemodul 1 für ein Kraftfahrzeug mit einer Frontabdeckung 2. Das Diagnosemodul 1 weist ferner einen Diagnosestecker 4 auf.

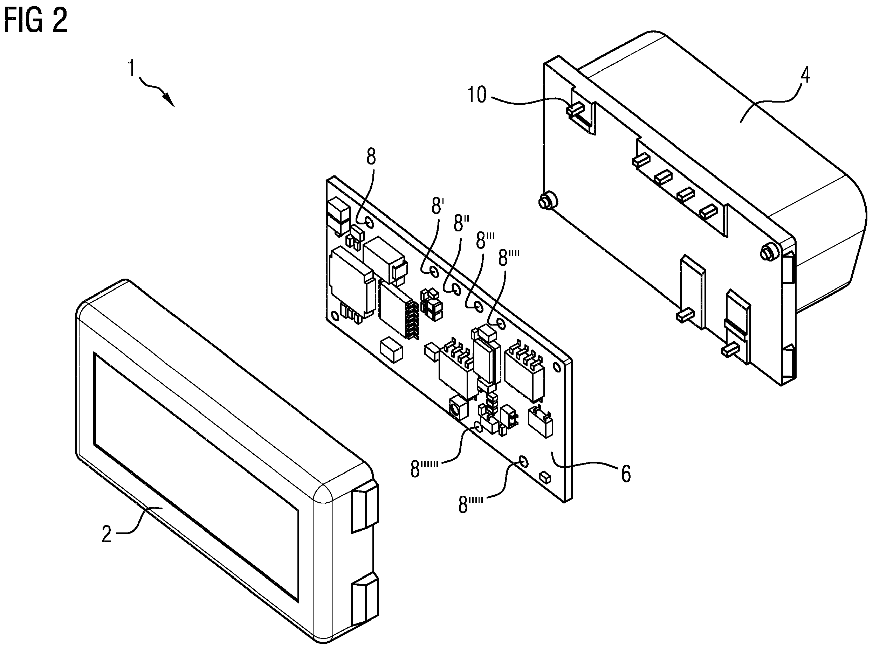

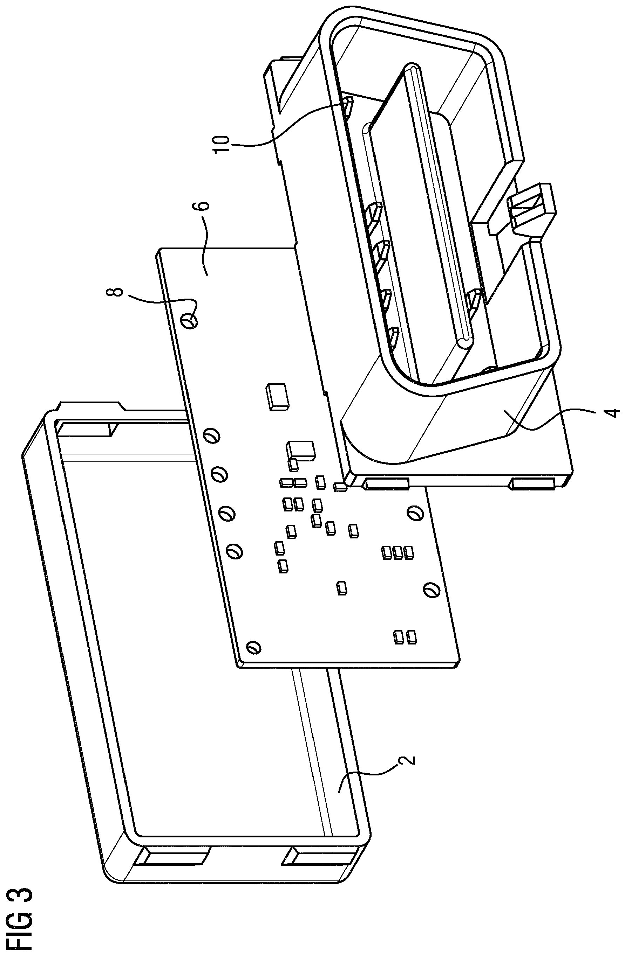

Aus Figur 2, die eine Explosionsdarstellung des Diagnosemoduls 1 zeigt, ist erkennbar, dass zwischen der Frontabdeckung 2 und dem Diagnosestecker 4 in dem Diagnosemodul 1 eine Leiterplatte 6 angeordnet ist. Die Leiterplatte 6 ist mit elektronischen Bauteilen bestückt und weist in ihrem Randbereich unter anderem sieben gleichartige Ausnehmungen 8, 8', 8", 8"', 8"", 8""', 8""" (siehe auch Figur 3), die als Durchgangsausnehmungen ausgebildet sind, auf. Diese sieben Ausnehmungen 8 der Leiterplatte 6 korrespondieren mit sieben Steckkontakten 10 des Diagnosesteckers 4.

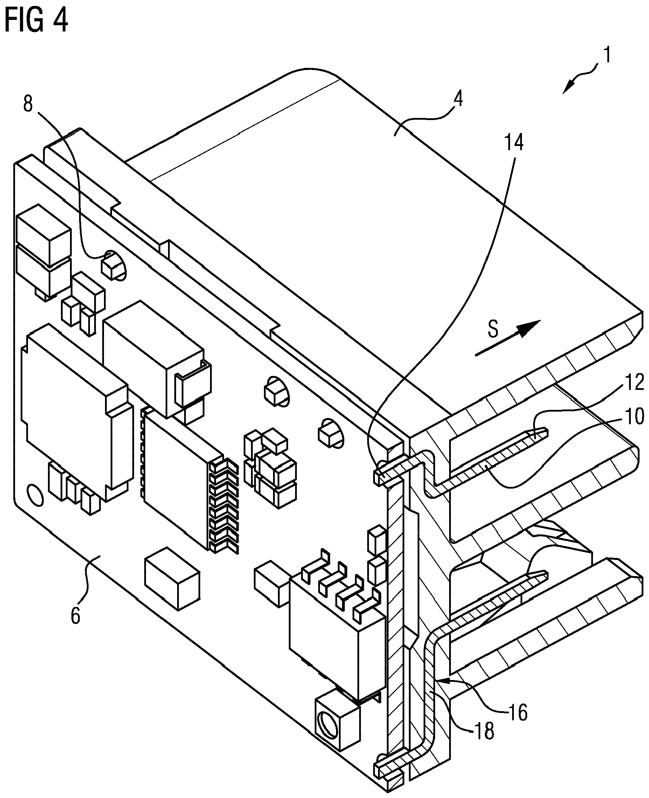

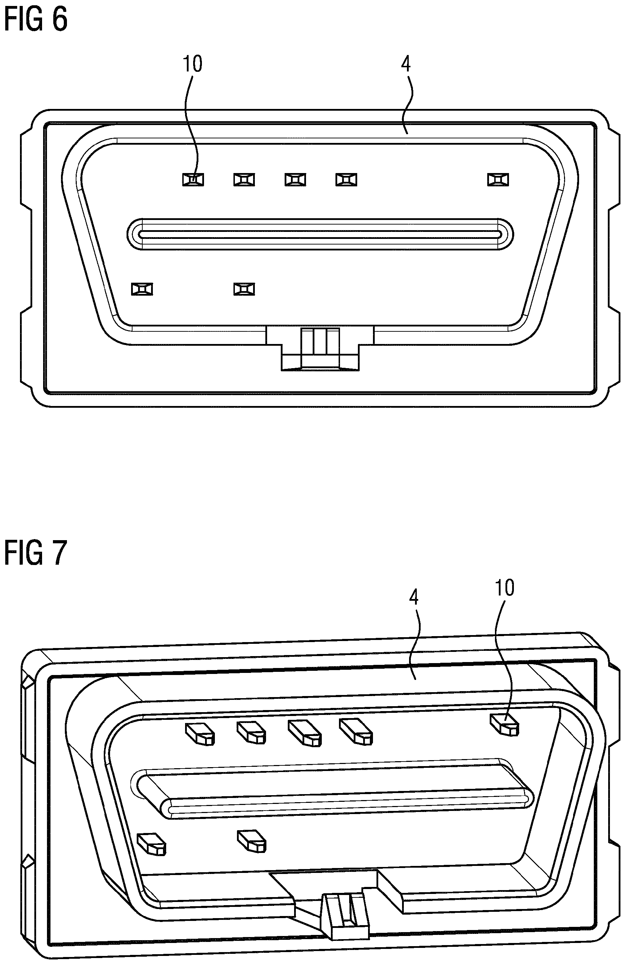

Figur 4 zeigt einen Ausschnitt des Diagnosemoduls 1 in einer Schnittansicht. Das Diagnosemodul 1 weist den Diagnosestecker 4 mit den Steckkontakten 10 (siehe auch Figuren 6, 7) und die Leiterplatte 6 auf. Die Steckkontakte 10 sind mit der Leiterplatte 6 elektrisch kontaktiert.

Die Steckkontakte 10 weisen jeweils ein freies Steckkontaktende 12 und ein festes Steckkontaktende 14 auf, wobei jeweils das feste Steckkontaktende 14 dem jeweiligen freien Steckkontaktende 12 abgewandt ist. Die Leiterplatte 6 ist senkrecht zu den freien Steckkontaktenden 12 angeordnet. Damit ist die Leiterplatte 6 auch senkrecht zu einer Steckrichtung S angeordnet, wobei die Steckrichtung S die Richtung angibt, in der das Diagnosemodul 1, insbesondere der Diagnosestecker 4 des Diagnosemoduls 1, mit einer hier nicht dargestellten Diagnosesteckdose, zum Beispiel in einem Kraftfahrzeug, verbunden wird.

Die festen Steckkontaktenden 14 greifen jeweils in die Ausnehmungen 8 der Leiterplatte 6 ein, wobei die Ausnehmungen 8 die festen Steckkontaktenden 14 in der Ebene der Leiterplatte 6 jeweils vollständig umschließen. Die festen Steckkontaktenden 14 sind jeweils mit der Leiterplatte 6 elektrisch kontaktiert.

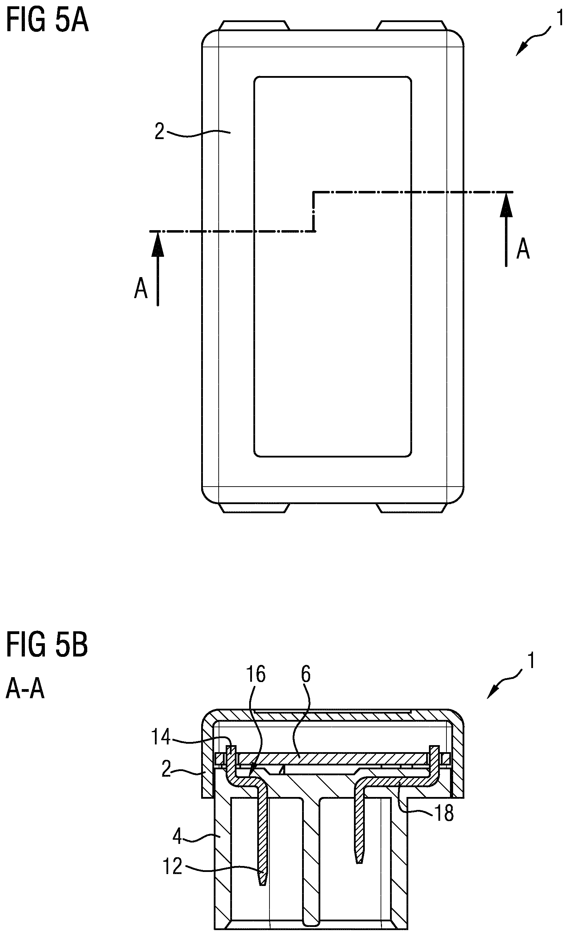

Eine Schnittansicht entlang Linie A - A in Figur 5A, die das Diagnosemodul 1 in einer Ansicht von vorne zeigt, zeigt Figur 5B. Hier ist zu erkennen, dass die Steckkontakte 10 jeweils zwischen ihren freien Steckkontaktenden 12 und ihren festen Steckkontaktenden 14 eine S-förmige Abkröpfung 16 aufweisen. Die S-förmigen Abkröpfungen 16 weisen jeweils einen parallel zu der Leiterplatte verlaufenden Steckkontaktabschnitt 18 auf.

Der Diagnosestecker 4 ist ein Kunststoffspritzgussbauteil. Die Steckkontakte 10 sind in das Kunststoffspritzgussbauteil eingespritzt. Jeweils die S-förmige Abkröpfung 16 mit einem parallel zu der Leiterplatte 6 verlaufenden Steckkontaktabschnitt 18 eines Steckkontakts 10 ist in das Kunststoffspritzgussbauteil eingespritzt.

## Patentansprüche

1. Diagnosemodul (1) für ein Kraftfahrzeug mit einem Steckkontakte (10) aufweisenden Diagnosestecker (4) und mit einer Leiterplatte (6), wobei die Steckkontakte (10) mit der Leiterplatte (6) elektrisch kontaktiert sind und jeweils ein freies Steckkontaktende (12) aufweisen und wobei die Leiterplatte (6) senkrecht zu den freien Steckkontaktenden (12) angeordnet ist, **dadurch gekennzeichnet, dass** die Steckkontakte (10) jeweils ein dem jeweiligen freien Steckkontaktende (12) abgewandtes festes Steckkontaktende (14) aufweisen, wobei die festen Steckkontaktenden (14) in die festen Steckkontaktenden (14) in der Ebene der Leiterplatte (6) jeweils vollständig umschließende Ausnehmungen (8) der Leiterplatte (6) eingreifen und jeweils mit der Leiterplatte (6) elektrisch kontaktiert sind.

2. Diagnosemodul nach Anspruch 1, **dadurch gekennzeichnet, dass** die Ausnehmungen (8) Durchgangsausnehmungen der Leiterplatte (6) sind.

3. Diagnosemodul nach Anspruch 2, **dadurch gekennzeichnet, dass** die festen Steckkontaktenden (14) die Leiterplatte (6) durch die jeweilige Ausnehmung (8) durchgreifen.

4. Diagnosemodul nach einem der vorhergehenden Ansprüche, **dadurch gekennzeichnet, dass** die Ausnehmungen (8) in einem Randbereich der Leiterplatte (6) angeordnet sind.

5. Diagnosemodul nach einem der vorhergehenden Ansprüche, **dadurch gekennzeichnet, dass** die festen Steckkontaktenden (14) in der jeweiligen Ausnehmung (8) mit der Leiterplatte (6) elektrisch kontaktiert sind.

6. Diagnosemodul nach einem der vorhergehenden Ansprüche, **dadurch gekennzeichnet, dass** der Diagnosestecker (4) höchstens zehn Steckkontakte aufweist.

7. Diagnosemodul nach einem der vorhergehenden Ansprüche, **dadurch gekennzeichnet, dass** die Steckkontakte (10) jeweils zwischen ihren freien Steckkontaktenden (12) und ihren festen Steckkontaktenden (14) eine S-förmige Abkröpfung (16) aufweisen.

8. Diagnosemodul nach Anspruch 7, **dadurch gekennzeichnet, dass** die S-förmigen Abkröpfungen (16) jeweils einen parallel zu der Leiterplatte (6) verlaufenden Steckkontaktabschnitt (18) aufweisen.

9. Diagnosemodul nach einem der vorhergehenden Ansprüche, **dadurch gekennzeichnet, dass** der Diagnosestecker (4) ein Kunststoffbauteil ist und dass die Steckkontakte (10) in das Kunststoffbauteil eingeformt sind.

10. Diagnosemodul nach Anspruch 9, **dadurch gekennzeichnet, dass** jeweils ein parallel zu der Leiterplatte (6) verlaufender Steckkontaktabschnitt (18) in das Kunststoffbauteil eingeformt ist.
